# EUROPEAN PATENT APPLICATION

(11) **EP 2 802 021 A1**
(43) Date of publication of application: **12.11.2014**
(21) Application number: 12864527.2
(22) Date of filing: 10.12.2012
(51) Int. Cl.: H01L 35/30

(54) **THERMOELECTRIC GENERATOR**

(30) Priority: 05.01.2012 JP 2012000570
(71) Applicant: Futaba Industrial Co. Ltd., Okazaki-shi, Aichi 444-8558 (JP)
(72) Inventor: KANIE, Hiroki, Okazaki-shi Aichi 444-8558 (JP); OKAMI, Hirohisa, Okazaki-shi Aichi 444-8558 (JP)
(74) Representative: Johnson, Yvonne Catherine
(86) International application number: PCT/JP2012/081962
(87) International publication number: WO 2013/103069

(57) **Abstract**

A thermoelectric generator includes a thermoelectric element and a casing to house the thermoelectric element, the casing including a first casing member and a second casing member to house the thermoelectric element so as to pressingly hold the thermoelectric element in between the first and second casing members, wherein a rib is formed around at least one of a surface of the first casing member and a surface of the second casing member, the surfaces pressingly holding the thermoelectric element therebetween while the first casing member and the second casing member house the thermoelectric element therein.

## Description

### CROSS-REFERENCE TO RELATED APPLICATIONS

This international application claims the benefit of Japanese Patent Application No. 2012-000570 filed January 5, 2012 in the Japan Patent Office, and the entire disclosure of Japanese Patent Application No. 2012-000570 is incorporated herein by reference.

### TECHNICAL FIELD

The present invention relates to a thermoelectric generator.

### BACKGROUND ART

Conventionally, a thermoelectric generator having an element that generates electricity by temperature difference (a thermoelectric element) is known. For example, Patent Document 1 indicates a thermoelectric generator (thermoelectric element unit) for an automobile, wherein the thermoelectric generator is for recovering thermal energy, which is obtained from exhaust gas of an internal combustion engine, as electric energy. This thermoelectric generator is sealed with a casing and is penetrated by an exhaust pipe and a cooling water pipe, through which high-temperature exhaust gas, as well as cooling water circulated from the internal combustion engine are supplied. Then, thermal energy of the exhaust gas is transferred to a thermoelectric element by a high-temperature-side heat exchanger disposed at an exhaust pipe side, and the thermal energy of the thermoelectric element is transferred to the cooling water by a low-temperature-side heat exchanger disposed at a cooling water pipe side. By this means, the thermoelectric element generates electricity by a temperature difference that occurs on the thermoelectric element.

### PRIOR ART DOCUMENTS

### PATENT DOCUMENTS

Patent Document 1: Japanese Unexamined Patent Application Publication No. 2010-106755

### SUMMARY OF THE INVENTION

### PROBLEMS TO BE SOLVED BY THE INVENTION

In one aspect of the present invention, it is preferable to improve the power generation efficiency of a thermoelectric element in a thermoelectric generator of this kind.

### MEANS FOR SOLVING THE PROBLEMS

A thermoelectric generator as a first example configuration includes a thermoelectric element and a casing to house the thermoelectric element; wherein the casing includes a first casing member and a second casing member to house the thermoelectric element so as to pressingly hold the thermoelectric element in between the first and second casing members, wherein a rib is formed around at least one of a surface of the first casing member and a surface of the second casing member, the surfaces pressingly holding the thermoelectric element therebetween while the first casing member and the second casing member house the thermoelectric element therein.

A thermoelectric generator as a second example configuration includes a thermoelectric element, a casing to house the thermoelectric element, and an insulating member for each of a low-temperature-side and a high-temperature-side to insulate the casing from the thermoelectric element; wherein a resin is used for the insulating member provided at the low-temperature-side.

### BRIEF DESCRIPTION OF THE DRAWINGS

FIG. 1A is a plan view, FIG. 1B is a front view, and FIG. 1C is a side view of a thermoelectric generator.
FIG. 2 is a cross-sectional view showing an internal structure of the thermoelectric generator.

### EXPLANATION OF REFERENCE NUMERALS

1... thermoelectric generator, 11... thermoelectric element, 12... lower case, 13... upper case, 14... high-temperature-side insulating member, 15... low-temperature-side insulating member, 16... electrode terminal, 17... copper wire, 121... abutting surface, 122... rib, 123... flange part, 131... abutting surface, 132...rib, 133...flange part

### MODE FOR CARRYING OUT THE INVENTION

Hereinafter, an embodiment to which the present invention is applied is described by referring to the drawings.

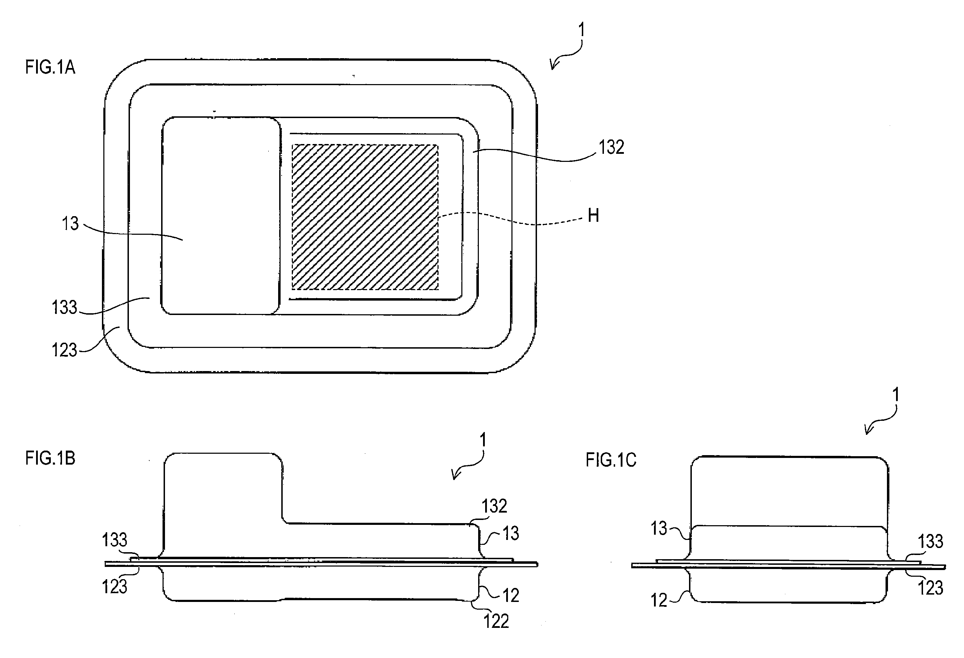

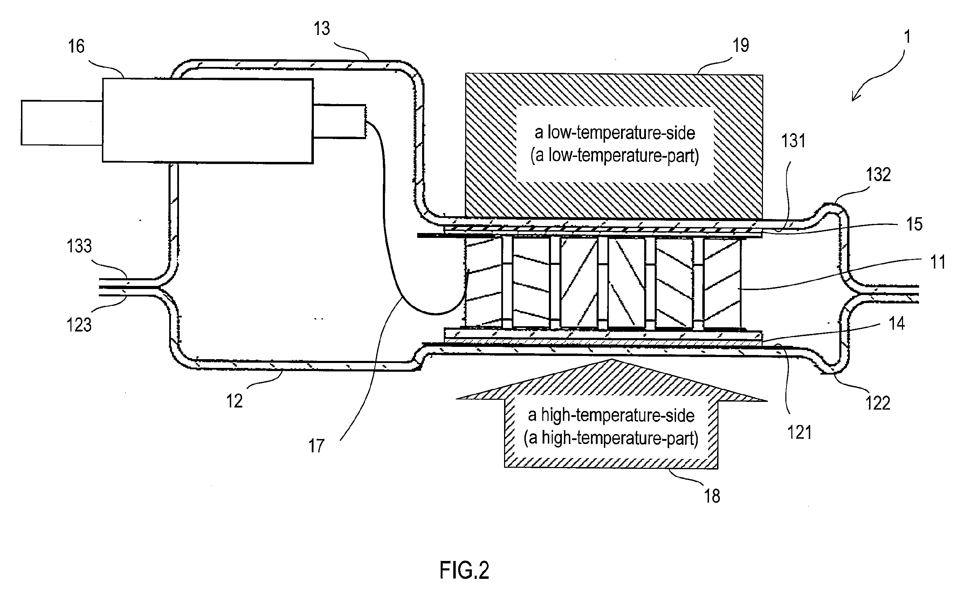

FIG. 1A is a plan view of a thermoelectric generator 1 in this embodiment, FIG. 1B is a front view of the thermoelectric generator 1, and FIG. 1C is a side view of the thermoelectric generator 1. In addition, FIG. 2 is a cross-sectional view showing an internal structure of the thermoelectric generator 1.

The thermoelectric generator 1 includes a thermoelectric element 11, a lower case 12, an upper case 13, a high-temperature-side insulating member 14, and a low-temperature-side insulating member 15.

The thermoelectric element 11 is an element that generates electricity by temperature difference; has a cuboid shape having a square planar view; and is disposed so as to have a lower surface facing a high-temperature-side (a high-temperature-part) 18 and an upper surface facing a low-temperature-side (a low-temperature-part) 19. In FIG. 1A, an area shown as H indicates a position of the thermoelectric element 11 in planar view.

The lower case 12 and the upper case 13 are metallic members forming a casing to house the thermoelectric element 11. The thermoelectric element 11 is housed in the casing in order to inhibit oxidation of the thermoelectric element 11 at high temperatures, and the casing is sealed with an inert gas (e.g., argon gas) enclosed therein.

The lower case 12 has a tray-like shape having an approximately rectangular planar view. And on an inner surface (a bottom surface) of the lower case 12, an abutting surface (a heat exchange section) 121, which abuts the thermoelectric element 11 via the high-temperature-side insulating member 14 is formed. The abutting surface 121 is formed flat (into a plane surface) and projects upward compared with portions other than the abutting surface 121. Therefore, an outer surface (a lower surface) of the lower case 12 has a recess for the portion of the abutting surface 121, and a rib structure where a rib 122, which projects so as to surround the recess, is formed. Further, a flange part 123, which extends horizontally, is formed around an outer edge of the lower case 12.

The upper case 13 has a tray-like shape having an approximately rectangular planar view similar to that of the lower case 12, and is disposed so as to cover an upper opening of the lower case 12. A housing space to house an electrode terminal 16 is formed in the upper case 13. In addition, the electrode terminal 16 is connected with the thermoelectric element 11 via a copper wire 17.

An abutting surface (a heat exchange section) 131, which abuts the thermoelectric element 11 via the low-temperature-side insulating member 15, is formed at an inner surface (a ceiling surface) of the upper case 13. The abutting surface 131 is formed flat (into a plane surface), and projects downward compared with portions other than the abutting surface 121. Therefore, an outer surface (an upper surface) of the upper case 13 has a recess for the portion of the abutting surface 131, and a rib structure where a rib 132, which projects so as to surround the recess, is formed. Further, a flange part 133, which extends horizontally, is formed around an outer edge of the upper case 13.

The flange part 123 of the lower case 12 and the flange part 133 of the upper case 13 are welded together, and the thermoelectric element 11 is sealed within the casing formed with the lower case 12 and the upper case 13. Here is an explanation of a manufacturing process for housing the thermoelectric element 11 within the casing. The lower case 12 and the upper case 13 are designed to a size such that there is a clearance between the flange part 123 and the flange part 133 respectively, while holding the thermoelectric element 11 in between. The flange part 123 and the flange part 133 are then welded together while the lower case 12 and the upper case 13 are vertically pressed together to eliminate the clearance. As a consequence, the lower case 12 and the upper case 13 are welded together while the thermoelectric element 11 is pressingly held in between the abutting surface 121 and the abutting surface 131. In this process, because of strong rigidities of the lower case 12 and the upper case 13 due to their rib structures, where the rib 122 and the rib 132 are formed respectively, deformation of pressing surfaces (the abutting surface 121 and the abutting surface 131) is restrained, and surface pressure enough to uniformly press the entire surface of the thermoelectric element 11 is secured.

The high-temperature-side insulating member 14 is a ceramic plate-like insulating member, which is disposed to be held in between the thermoelectric element 11 and the abutting surface 121 to insulate the lower case 12 from the thermoelectric element 11.

The low-temperature-side insulating member 15 is a resin plate-like insulating member, which is disposed to be held in between the thermoelectric element 11 and the abutting surface 131 to insulate the upper case 13 from the thermoelectric element 11. Compared with the high-temperature-side insulating member 14, the low-temperature-side insulating member 15 has a nature of being susceptible to deformation by external forces (being elastic), thus can enhance its adhesion with the thermoelectric element 11 and with the upper case 13. In addition, since the low-temperature-side insulating member 15 is disposed so as to face the low-temperature-side (the low-temperature-part) 19, a resin having a low heat-resistant temperature can be used for the low-temperature-side insulating member 15.

As explained above, the thermoelectric generator 1 in this embodiment can enhance adhesion by securing flatness of the heat exchange sections (the abutting surface 121 and the abutting surface 131). Additionally, the structure to press the thermoelectric element 11 with a uniform surface pressure allows resistant of deviation caused by oscillation, detachment caused by thermal deformation, peeling of an electrode plate, and such of the thermoelectric element 11.

Furthermore, in the thermoelectric generator 1 in this embodiment, an insulating material (a resin in particular) used for the low-temperature-side insulating member 15, which is disposed so as to face the low-temperature-side (the low-temperature-part) 19, is different from an insulating material used for the high-temperature-side insulating member 14, which is disposed so as to face the high-temperature-side (the high-temperature-part) 18. Thus, adhesion of the low-temperature-side insulating member 15 with the thermoelectric element 11, and with the upper case 13 at the low-temperature-side can be enhanced.

Moreover, since the lower case 12 and the upper case 13 are designed to a size such that there is a clearance between the flange part 123 and the flange part 133 respectively, while holding the thermoelectric element 11 in between, fixation of the thermoelectric element 11 can be inexpensively realized.

The embodiment of the present invention is as described above; however, it is needless to say that the present invention can be practiced in various modes without being limited to the above-described embodiment.

## Claims

1. A thermoelectric generator comprising:
a thermoelectric element; and
a casing to house the thermoelectric element,
the casing including:
a first casing member; and
a second casing member to house the thermoelectric element so as to pressingly hold the thermoelectric element in between the first and second casing members,
wherein a rib is formed around at least one of a surface of the first casing member and a surface of the second casing member, the surfaces pressingly holding the thermoelectric element therebetween while the first casing member and the second casing member house the thermoelectric element therein.

2. A thermoelectric generator comprising;
a thermoelectric element;
a casing to house the thermoelectric element; and
an insulating member at each of a high-temperature-side and a low-temperature-side to insulate the casing from the thermoelectric element,
wherein a resin is used for the insulating member provided at the low-temperature-side.
